# EUROPEAN PATENT APPLICATION

(11) **EP 1 020 918 A2**
(43) Date of publication of application: **19.07.2000**
(21) Application number: 00300033.8
(22) Date of filing: 06.01.2000
(51) Int. Cl.: H01L 27/108, H01L 21/8242, H01L 21/02

(54) **DRAM capacitor and method of making the same**

(30) Priority: 13.01.1999 US 115785; 30.07.1999 US 364603
(71) Applicant: LUCENT TECHNOLOGIES INC., Murray Hill, New Jersey 07974-0636 (US)
(72) Inventor: Chaudhry, Samir, Orlando, Florida 32839 (US); Chetlur, Sundar Srinivasan, Orlando, Orange, FL 32836 (US); Layadi, Nace, Singapore (SG); Roy, Pradip Kumar, Orlando, Florida 32819 (US); Vaidya, Hem M., Singapore 738375 (SG)
(74) Representative: Johnston, Kenneth Graham

(57) **Abstract**

An integrated circuit capacitor includes a first dielectric layer adjacent a substrate and having a trench therein, and a metal plug comprising an upper portion extending upwardly into the trench, and a lower portion disposed in the first dielectric layer. The lower portion has a tapered width which increases in a direction toward the substrate to thereby secure the metal plug in the dielectric layer. Preferably, the upper portion is also tapered. Furthermore, a second dielectric layer is adjacent the metal plug with an upper electrode thereon.

## Description

### Related Application

This application is based upon prior filed copending provisional application Serial No. 60/115,785 filed January 13, 1999.

### Field Of The Invention

The present invention relates to the field of semiconductor devices, and, more particularly, to a capacitor.

### Background Of The Invention

Capacitors are used extensively in electronic devices for storing an electric charge. A capacitor includes two conductive plates or electrodes separated by an insulator. The capacitance, or amount of charge held by the capacitor per applied voltage, depends upon the area of the plates, the distance between them, and the dielectric value of the insulator. Capacitors may be formed within a semiconductor device, such as, for example, a dynamic random access memory (DRAM) or an embedded DRAM.

As semiconductor memory devices become more highly integrated, the area occupied by the capacitor of a DRAM storage cell is reduced, thus decreasing the capacitance of the capacitor due to a smaller electrode surface area. However, a relatively large capacitance is desired to prevent loss of stored information. Therefore, it is desirable to reduce the cell dimensions and yet obtain a high capacitance, which achieves both high cell integration and reliable operation.

One technique for increasing the capacitance while maintaining the high integration of the storage cells is directed toward the shape of the capacitor electrodes. In this technique, the polysilicon layer of the capacitor electrodes may have protrusions, fins, cavities, etc., to increase the surface area of the capacitor electrode, thereby increasing its capacitance while maintaining the small area occupied on the substrate surface.

Instead of forming the capacitor on the substrate surface, capacitors are also formed above the substrate, i.e., they are stacked above the substrate. The surface area of the substrate can then be used for forming transistors. U.S. Patent No. 5,903,493 to Lee discloses a capacitor formed above a tungsten plug. The surface area of the capacitor is increased by etching a trench in the dielectric layer around the tungsten plug. The tungsten plug interfaces with an interconnection line, thus allowing different layers formed above the substrate to be connected.

The trench is patterned by conventional etching or other suitable techniques. The fundamental limit on how far the trench can be etched is determined by how well the tungsten plug is secured within the dielectric layer. Typically, the depth of the trench is limited to about one half the thickness of the dielectric layer. After the trench has been etched, a capacitor is formed above the tungsten plug. Unfortunately, if the trench is etched beyond one half the thickness of the dielectric, the tungsten plug is more likely to become loose and fall out. This physical separation between the tungsten plug and the underlying metal interconnection with interconnect line can cause open circuits to be formed resulting in complete failure of the device or circuit.

A known approach to secure the metal plug uses a metal plug with an anchor portion extending into the interconnect line. This approach uses an additional wet etch, reactive ion etch (RIE) or plasma etch to form an anchor hole in the interconnect line and below the dielectric layer.

### Summary Of The Invention

In view of the foregoing background, it is therefore an object of the present invention to increase the capacitance of an integrated circuit capacitor without decreasing the reliability of the capacitor.

This and other advantages, features and objects in accordance with the present invention are provided by an integrated circuit capacitor including a first dielectric layer adjacent a substrate and having a trench therein, and a metal plug comprising an upper portion extending upwardly into the trench, and a lower portion disposed in the first dielectric layer and having a tapered width which increases in a direction toward the substrate. The tapered width of the metal plug secures or anchors the metal plug in the dielectric layer. The angle of taper may preferably be greater than about 2 and more preferably greater than about 5 . The metal plug may be formed of tungsten. Furthermore, a second dielectric layer is adjacent the metal plug with an upper electrode thereon. Preferably, a lower electrode is between the metal plug and the second dielectric layer.

The upper portion may also have a tapered width which increases in the direction toward the substrate. Also, the trench depth is preferably greater than about half a thickness of the first dielectric layer, e.g. greater than about 250 angstroms. The capacitor preferably includes an interconnection line extending below the first dielectric layer and connected to the metal plug. Additionally, the upper portion of the metal plug preferably has an upper most surface substantially co-planar with an adjacent uppermost surface of the first dielectric layer, and the upper portion preferably extends upwardly in a medial portion of the trench.

### Brief Description Of The Drawings

FIG. 1 is a cross-sectional view of an integrated circuit capacitor in accordance with the present invention.
FIGS. 2-5 are cross-sectional views illustrating the process steps for forming a capacitor in accordance with the present invention.

### Detailed Description Of The Preferred Embodiments

The present invention will now be described more fully hereinafter with reference to the accompanying drawings, in which preferred embodiments of the invention are shown. This invention may, however, be embodied in many different forms and should not be construed as limited to the embodiments set forth herein. Rather, these embodiments are provided so that this disclosure will be thorough and complete, and will fully convey the scope of the invention to those skilled in the art. Like numbers refer to like elements throughout. The dimensions of layers and regions may be exaggerated in the figures for clarity.

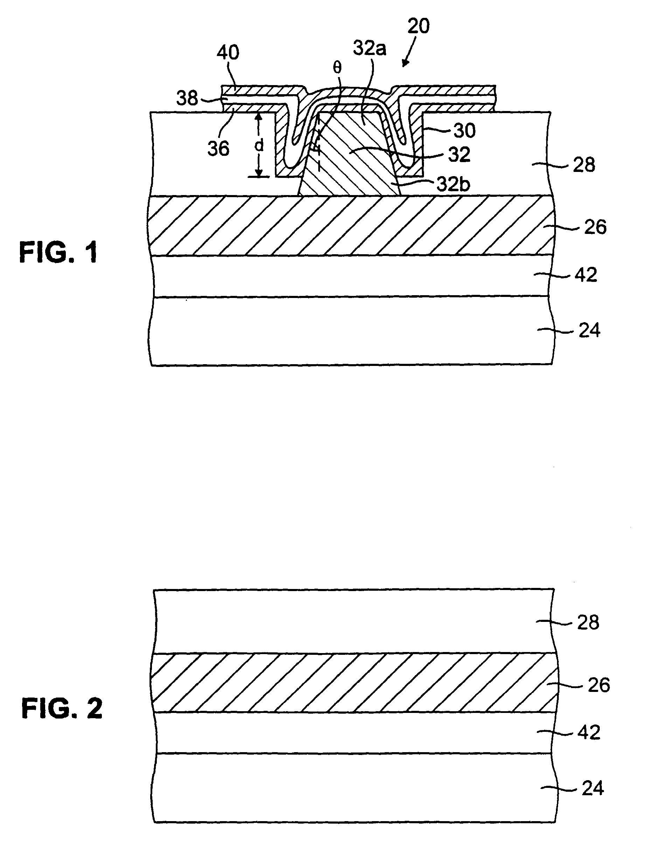

Referring initially to FIG. 1, a cross-sectional view of an integrated circuit capacitor **20** including a tapered metal plug **32** is now described. The integrated circuit capacitor **20** is formed on a substrate **24** with an interconnect line **26** adjacent the substrate, and a first dielectric layer **28** is on the interconnection line. The first dielectric layer **28** includes a trench **30** formed therein. The trench **30** is formed around the tapered plug **32** allowing the capacitor **20** to occupy a greater surface area, thus increasing its capacitance.

The tapered plug **32** includes an upper portion **32a** extending upwardly into the trench **30**, and a lower portion **32b** disposed in the first dielectric layer **28**. The tapered plug **32** has a tapered width which increases in a direction toward the substrate **24.** Thus, the lower portion **32b** of the tapered plug **32** engages lowermost portions of the first dielectric layer **28** to secure or anchor the tapered plug **32**. The angle of taper **,** as measured from an imaginary line perpendicular to an upper plane of the metal plug **32**, may preferably be greater than about 2 and more preferably greater than about 5 .

Because the tapered plug **32** is secured, a depth **d** of the trench can be greater than half the thickness of the first dielectric layer **28** without the tapered plug becoming loose and possibly separating from the underlying interconnect line **26**. If this were to occur, an open circuit could result and lead to failure of the device or the circuit incorporating the integrated circuit capacitor **20**. The capacitor **20** includes lower and upper electrodes **36, 40** and a second dielectric layer **38** therebetween. The lower electrode **36** lines the trench **30** and contacts the tapered plug **32**. The second dielectric layer **38** overlies the lower electrode **36**, and the upper electrode **40** overlies the second dielectric layer. Alternatively, for example, the capacitor may include the tapered plug **32** as the lower electrode, the second dielectric layer **38** lining the trench **30** and the upper electrode **40** overlying the second dielectric layer.

As semiconductor devices, e.g., an embedded dynamic random access memory (EDRAM), become more highly integrated, the capacitance of a capacitor decreases because of its smaller electrode surface area. However, a relatively large capacitance is desired to prevent loss of stored data. Therefore, increasing the depth **d** of the trench in accordance with the present invention increases the surface area of the lower and upper electrodes **36, 40**. This advantageously increases the capacitance of the capacitor **20**.

The interconnect line **26** may include a multilayer interconnect formed on an insulating layer **42**. The insulating layer **42** is formed on or above the semiconductor substrate **24**. The semiconductor substrate **24** contains a plurality of active devices, such as transistors, which are connected together into functional circuits by the interconnect line **26**.

The multilayer interconnect may include a conductive capping layer, a bulk conductor, and an electromigration barrier layer (not shown) as would readily be appreciated by those skilled in the art. Additionally, an anti-reflective coating (ARC), such as titanium nitride, may be formed on the interconnect line **26**.

The integrated capacitor **20** is electrically connected to the interconnect line **26** by the tapered plug **32**. The tapered plug **32** preferably includes tungsten or any suitable, electrically conductive material such as aluminum, titanium or titanium nitride. An important feature of the present invention is that the tapered plug **32** is secured to the interconnect line **26** to prevent the plug from becoming loose and possibly separating from the underlying interconnection line.

As previously discussed, the capacitance of the capacitor **20** is increased by forming a trench **30** in the first dielectric layer **28**. The tapered plug **32** extends upwardly in a medial portion of the trench **30**. The trench **30** is patterned, e.g., by conventional etching or other suitable techniques. For example, an etch stop (not shown), such as silicon nitride, can be formed within the first dielectric layer **28** during its formation. Accordingly, the etch stop determines the actual depth **d** of the trench **30**.

Without the tapered width of the tapered plug **32** securing the tapered plug to the interconnect line **26**, the depth **d** of the trench **30** would typically be limited to about half the thickness of the first dielectric layer **28**, which is generally in a range of about 4,000 to 6,000 angstroms. Accordingly, with the tapered plug **32,** the depth **d** of the trench **30** is in a range of about 2,000 to 4,500 angstroms depending on the actual thickness of the first dielectric layer **28**.

Once the trench **30** has been formed, the capacitor **20** is then formed. The lower electrode **36** lines the trench **30** and contacts the tapered plug **32**. The lower electrode **36** may be made from any material suitable for conducting and holding an electric charge. Suitable materials include titanium nitride, aluminum, copper, silver, titanium or noble metals such as gold, platinum and/or palladium. The thickness of the lower electrode **36** is in a range of about 75 to 750 angstroms. It is also possible for the lower electrode **36** to be multi-layered, e.g., having a layer of titanium coated with a layer of titanium nitride.

The second dielectric layer **38** overlies the lower electrode **36** and is formed from any suitable dielectric, e.g., silicon dioxide, silicon nitride and/or any material or alloy of material having a suitably large dielectric constant. Other suitable materials include tantalum pentoxide and barium strontium titantate, for example. The thickness of the second dielectric **38** may be in a range of about 25 to 250 angstroms.

The upper electrode **40** overlies the second dielectric layer **38**. Like the lower electrode **36**, the upper electrode **40** is capable of being made from any material suitable for conducting and holding an electric charge. The thickness of the upper electrode **40** may be in a range of about 150 to 2,500 angstroms. It is also possible for the upper electrode **40** to be multi-layered or even doped, e.g. aluminum alloyed with a second material, such as copper or silicon.

A method for making the integrated circuit capacitor **20** including a tapered plug **32** as described above will now be further discussed with reference to FIGS. 2-5. The semiconductor substrate **24** is preferably silicon, or may be silicon or a polysilicon layer or structure formed on the substrate. A plurality of devices, such as transistors (not shown), are formed in the substrate **24** using well known techniques. Next, the dielectric layer **42**, such as a doped or undoped silicon dioxide, is formed over the substrate **24** with well known techniques, such as thermal growth or deposition.

Next, the interconnection line **26** is formed on the dielectric layer **42**. As an example, an approximately 4,500 angstrom thick aluminum alloy layer comprising approximately 1% copper may be formed on a titanum layer using well known techniques, such as sputtering. An aluminum alloy layer has low resistivity and is readily procured; however, other low resistance materials may be used as a bulk conductor in the interconnect line **26**, as will be appreciated by those skilled in the art. As discussed above, the interconnect line **26** may be a multilayer interconnect as would readily be appreciated by those skilled in the art. Additionally, an anti-reflective coating (ARC), such as titanium nitride, may be formed on the interconnect line **26**.

The first dielectric layer **28**, such as a doped silicon dioxide, is formed over the interconnect line **26**. Any well known technique can be used to form the first dielectric layer **28**, such as chemical vapor deposition (CVD). The first dielectric layer **28** is preferably planarized at this time by chemical-mechanical polishing or etch back to form a planar top surface. The resulting thickness of the first dielectric layer **28** should be thick enough after planarization to provide adequate electrical isolation of the interconnect line **26** from a subsequent level of metallization. For example, an approximate thickness of 4,000 to 6,000 angstroms provides suitable isolation.

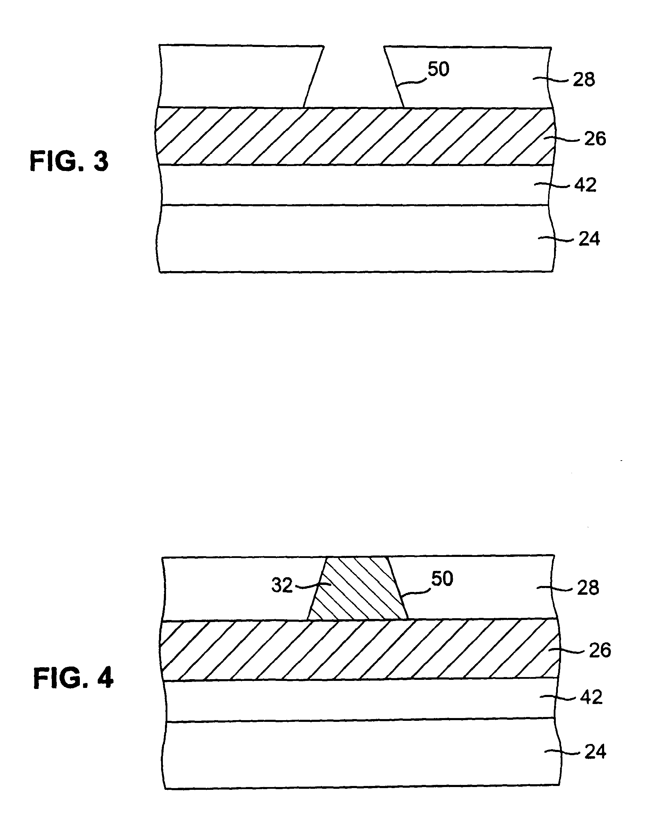

A photoresist layer (not shown) is formed and patterned over the first dielectric layer **28** using well known photolithography techniques to define the location where a tapered via hole **50** is to be formed. Next, the exposed portions of the first dielectric layer **28** are etched. The tapered via hole **50** is etched until the interconnect line **26** is exposed, as shown in FIG. 3. In one embodiment, a directional reactive ion etch (RIE) is used to form the via hole **50**. A free tilt wafer holder may be used to achieve the desired taper using the RIE process. The tapered via hole **50** could then be etched using standard etch conditions. Typical etchants are C₄F₈/CO/Ar/O₂ mixtures. The wafer could be directionally etched at one angle, then rotated 180 , returned to the etch chamber, tilted and etched again. This would produce the desired tapered shape to the via hole **50**.

Referring now to FIG. 4, the via hole **60** is filled with a conductive material, preferably tungsten, using well known techniques for forming the tapered metal plug **32**. Prior to forming the tapered plug **32**, a nucleation layer, such as titanium nitride or tantalum nitride, may be sputter deposited on the side walls of the via hole **50**, as would be appreciated by those skilled in the art. Also, a thin adhesion/barrier layer, such as titanium or titanium nitride can be blanket deposited into the via hole **50** using well known techniques such as sputtering. The conductive material is deposited into the via hole **50** until the via hole **50** is filled. A chemical-mechanical polishing technique may then be used to etch back the adhesion/barrier metals and any conductive material deposited on the first dielectric layer **28**. Other well known etch back techniques can be used, such as reactive ion etching (RIE).

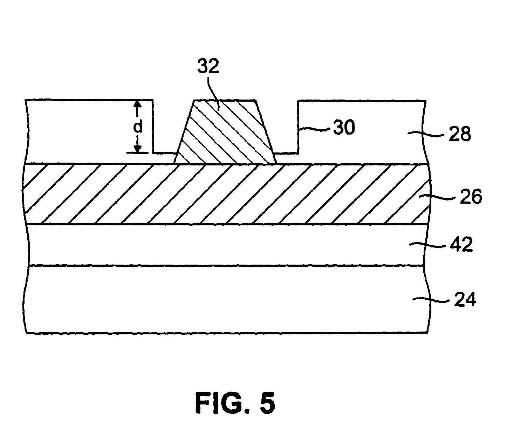

A trench **30** is now formed around the metal plug **32**, as best shown in FIG. 5. The trench **30** is formed by patterning a trench around the metal plug **32** by conventional etching or other suitable techniques. For example, a silicon nitride etch stop may be formed within the first dielectric layer **28** during its formation. Accordingly, the etch stop would determine the actual depth **d** of the trench **30**. Because the metal plug **32** is secured to the interconnect line **26**, positioning of the etch stop can be greater than half the thickness of the first dielectric layer **28**. This advantageously allows the capacitance of the capacitor **20** to be increased because of the increased surface area available for forming the capacitor.

Once the trench **30** has been formed, the lower electrode **36** of the capacitor **20** is formed by depositing an electrically conductive material on the first dielectric layer **28**, including the trench **30** and the metal plug **32**, as illustrated in FIG. 1. The lower electrode **36** is then selectively formed by an appropriate technique, such as chemical vapor deposition (CVD). Other methods of depositing the lower electrode **36** may include sputtering, reactive sputter etching (RSE), and plasma enhanced chemical vapor deposition (PECVD). The second dielectric layer **38** is selectively formed over the lower electrode **36** using an appropriate technique. The second dielectric layer **38** may be deposited using CVD or any of the other techniques referenced with respect to depositing the lower electrode **36**. The upper electrode **40** is then deposited by CVD, for example, and selectively patterned by an appropriate patterning technique. Other methods of depositing the upper electrode **40** include physical vapor deposition (PVD), sputtering, reactive sputter etching (RSE), and plasma enhanced chemical vapor deposition (PECVD). The capacitor **20** thus includes the lower and upper electrodes **36, 40** and the second dielectric layer **38** therebetween, as shown in FIG. 1.

Many modifications and other embodiments of the invention will come to the mind of one skilled in the art having the benefit of the teachings presented in the foregoing descriptions and the associated drawings. Therefore, it is to be understood that the invention is not to be limited to the specific embodiments disclosed, and that modifications and embodiments are intended to be included within the scope of the appended claims.

## Claims

1. An integrated circuit capacitor comprising:
a substrate;
a first dielectric layer adjacent said substrate and having a trench therein;
a metal plug comprising
an upper portion extending upwardly into said trench, and
a lower portion disposed in said first dielectric layer and having a tapered width which increases in a direction toward said substrate to secure said metal plug in said first dielectric layer;
a second dielectric layer adjacent said metal plug; and
an upper electrode layer on said second dielectric layer.

2. An integrated circuit capacitor comprising:
a substrate;
an interconnection line adjacent said substrate;
a first dielectric layer on said interconnection line and having a trench therein;
a metal plug comprising
an upper portion extending upwardly into said trench, and
a lower portion disposed in said first dielectric layer and contacting said interconnection line, said lower portion having a tapered width which increases in a direction toward said substrate;
a second dielectric layer adjacent said metal plug; and
an upper electrode layer on said second dielectric layer.

3. An integrated circuit capacitor comprising:
a substrate;
a first dielectric layer adjacent said substrate and having a trench therein, the trench having a depth greater than about half a thickness of said first dielectric layer;
a metal plug having a tapered width which increases in the direction of said substrate, said metal plug comprising
an upper portion extending upwardly into said trench, and
a lower portion disposed in said first dielectric layer;
a second dielectric layer adjacent said metal plug; and
an upper electrode layer on said second dielectric layer.

4. A capacitor according to claim 1,2 or 3, further comprising a lower electrode layer between said metal plug and said second dielectric layer.

5. A capacitor according to claim 1,2, or 3, wherein said upper portion or said upper portion and said lower portion has a tapered width which increases in the direction toward said substrate.

6. A capacitor, according to claim 1,2 or 3, wherein the tapered width of said metal plug or said lower portion of said metal plug has an angle of taper greater than about 2, or greater than about 5.

7. A capacitor according to claim 1,2, or 3, wherein the trench has a depth either greater than about 250 angstroms, or greater than about half a thickness of said first dielectric layer.

8. A capacitor according to claim 1,2, or 3, further comprising an interconnection line extending below said first dielectric layer and connected to said metal plug.

9. A capacitor according to claim 1,2, or 3, wherein said upper portion of said metal plug has an upper most surface substantially co-planar with an adjacent uppermost surface of said first dielectric layer.

10. A capacitor according to claim 1,2, or 3, wherein said metal plug comprises tungsten.

11. A capacitor according to claim 1,2, or 3, wherein said upper portion of said metal plug extends upwardly in a medial portion of the trench.
